# EUROPEAN PATENT APPLICATION

(11) **EP 3 242 329 A1**
(43) Date of publication of application: **08.11.2017**
(21) Application number: 15876629.5
(22) Date of filing: 16.09.2015
(51) Int. Cl.: H01L 29/78, H01L 29/423

(54) **HIGH VOLTAGE P TYPE LATERAL DOUBLE DIFFUSED METAL OXIDE SEMICONDUCTOR FIELD EFFECT TUBE**

(30) Priority: 05.01.2015 CN 201510003131
(71) Applicant: CSMC Technologies Fab1 Co., Ltd., Jiangsu 214028 (CN)
(72) Inventor: ZHANG, Guangsheng, Wuxi New District Jiangsu 214028 (CN); ZHANG, Sen, Wuxi New District Jiangsu 214028 (CN); BIAN, Peng, Wuxi New District Jiangsu 214028 (CN); HU, Xiaolong, Wuxi New District Jiangsu 214028 (CN)
(74) Representative: Manitz Finsterwald Patentanwälte PartmbB
(86) International application number: PCT/CN2015/089807
(87) International publication number: WO 2016/110128

(57) **Abstract**

A high voltage P-type lateral double-diffused metal oxide semiconductor field effect transistor (10) comprises: a substrate (100); an N-type lateral double-diffused metal oxide semiconductor field effect transistor (200) formed on the substrate (100); and a P-type metal oxide semiconductor field effect transistor (300) formed at a drain of the N-type lateral double-diffused metal oxide semiconductor field effect transistor (200); wherein a gate of the P-type metal oxide semiconductor field effect transistor (300) serves as a gate of the high voltage P-type lateral double-diffused metal oxide semiconductor field effect transistor (10); a drain of the P-type metal oxide semiconductor field effect transistor (300) serves as a drain of the high voltage P-type lateral double-diffused metal oxide semiconductor field effect transistor (10); a source of the N-type lateral double-diffused metal oxide semiconductor field effect transistor (200) serves as a source of the high voltage P-type lateral double-diffused metal oxide semiconductor field effect transistor (10).

## Description

### FIELD OF THE INVENTION

The present invention relates to a technical field of manufacturing semiconductor, and particularly relates to a high voltage P-type lateral double-diffused metal oxide semiconductor field effect transistor.

### BACKGROUND OF THE INVENTION

The conventional P-type lateral double-diffused metal oxide semiconductor field effect transistor (PLDMOS) structure requires a low-doped P-type drift region of a certain length to achieve high voltage resistance. Therefore, during high voltage integration of the high voltage N-type lateral double-diffused metal oxide semiconductor field effect transistor (NLDMOS) and PLDMOS, it needs another photoetching operation for the low-doped P-type region, which increases the process complexity and process costs.

### SUMMARY OF THE INVENTION

Accordingly, it is necessary to provide a high voltage P-type lateral double-diffused metal oxide semiconductor field effect transistor, which can achieve the high voltage resistance performance of the device by a simple process and a lower cost.

A high voltage P-type lateral double-diffused metal oxide semiconductor field effect transistor includes:
a substrate;
an N-type lateral double-diffused metal oxide semiconductor field effect transistor formed on the substrate; and
a P-type metal oxide semiconductor field effect transistor formed at a drain of the N-type lateral double-diffused metal oxide semiconductor field effect transistor;
wherein a gate of the P-type metal oxide semiconductor field effect transistor serves as a gate of the high voltage P-type lateral double-diffused metal oxide semiconductor field effect transistor; a drain of the P-type metal oxide semiconductor field effect transistor serves as a drain of the high voltage P-type lateral double-diffused metal oxide semiconductor field effect transistor; a source of the N-type lateral double-diffused metal oxide semiconductor field effect transistor serves as a source of the high voltage P-type lateral double-diffused metal oxide semiconductor field effect transistor.

The above high voltage P-type lateral double-diffused metal oxide semiconductor field effect transistor can enable the device to have the performance of the P-type metal oxide semiconductor field effect transistor when the device is turned on by disposing the P-type metal oxide semiconductor field effect transistor at the drain of the N-type lateral double-diffused metal oxide semiconductor field effect transistor; when turned off, the device resists the voltage by the N-type lateral double-diffused metal oxide semiconductor field effect transistor, so that the voltage resistance performance of the high voltage P-type lateral double-diffused metal oxide semiconductor field effect transistor can be achieved. The above high voltage P-type lateral double-diffused metal oxide semiconductor field effect transistor does not need to dispose a low-doped P-type drift region therein to achieve the voltage resistance, therefore, during the integration process, it does not need to increase the number of lithography layer and implantation, so as to have a simple manufacturing process and a lower cost.

### BRIEF DESCRIPTION OF THE DRAWINGS

To illustrate the technical solutions according to the embodiments of the present invention or in the prior art more clearly, the accompanying drawings for describing the embodiments or the prior art are introduced briefly in the following. Apparently, the accompanying drawings in the following description are only some embodiments of the present invention, and persons of ordinary skill in the art can derive other drawings from the accompanying drawings without creative efforts.
Fig. 1 is a schematic diagram of a high voltage P-type lateral double-diffused metal oxide semiconductor field effect transistor in an embodiment;
Fig. 2 is a equivalent structure of the high voltage P-type lateral double-diffused metal oxide semiconductor field effect transistor shown in Fig. 1.

### DETAILED DESCRIPTION OF THE EMBODIMENTS

Embodiments of the invention are described more fully hereinafter with reference to the accompanying drawings. The various embodiments of the invention may, however, be embodied in many different forms and should not be construed as limited to the embodiments set forth herein. Rather, these embodiments are provided so that this disclosure will be thorough and complete, and will fully convey the scope of the invention to those skilled in the art. Elements that are identified using the same or similar reference characters refer to the same or similar elements.

In this specification and drawings, the reference symbols N and P distributed to layers or regions represents that these layers or regions includes a plurality of electrons or holes. Further, the reference symbols + and - distributed to N or P represent that the concentration of the dopant is higher or lower than the concentration of the dopant in the layers to which such symbols are not distributed. In description of the following embodiments and drawings, similar components are distributed with similar reference symbols, and redundant illustration is omitted at here.

A high voltage P-type lateral double-diffused metal oxide semiconductor field effect transistor (PLDMOS transistor) includes: a substrate; an N-type lateral double-diffused metal oxide semiconductor field effect transistor (NLDMOS transistor) formed on the substrate; and a P-type metal oxide semiconductor field effect transistor (PMOS transistor) formed at a drain of the N-type lateral double-diffused metal oxide semiconductor field effect transistor. The N-type lateral double-diffused metal oxide semiconductor field effect transistor and the P-type metal oxide semiconductor field effect transistor can use the common field effect transistor structure in the art, and are not limited to a certain specific field effect transistor structure. In the embodiment, a gate of the P-type metal oxide semiconductor field effect transistor serves as a gate of the high voltage P-type lateral double-diffused metal oxide semiconductor field effect transistor; a drain of the P-type metal oxide semiconductor field effect transistor serves as a drain of the high voltage P-type lateral double-diffused metal oxide semiconductor field effect transistor; and a source of the N-type lateral double-diffused metal oxide semiconductor field effect transistor serves as a source of the high voltage P-type lateral double-diffused metal oxide semiconductor field effect transistor.

The above high voltage P-type lateral double-diffused metal oxide semiconductor field effect transistor can enable the device to have the performance of the P-type metal oxide semiconductor field effect transistor when the device is turned on by disposing the P-type metal oxide semiconductor field effect transistor at the drain of the N-type lateral double-diffused metal oxide semiconductor field effect transistor; when turned off, the device resists the voltage by the N-type lateral double-diffused metal oxide semiconductor field effect transistor, so that the voltage resistance performance of the high voltage P-type lateral double-diffused metal oxide semiconductor field effect transistor can be achieved. The above high voltage P-type lateral double-diffused metal oxide semiconductor field effect transistor does not need to dispose a low-doped P-type drift region therein to achieve the voltage resistance, therefore, during the integration process, it does not need to increase the number of lithography layer and implantation, so as to have a simple manufacturing process and a lower cost.

The high voltage P-type lateral double-diffused metal oxide semiconductor field effect transistor in the embodiment will be further illustrated in detail in combination with a specific embodiment in the following.

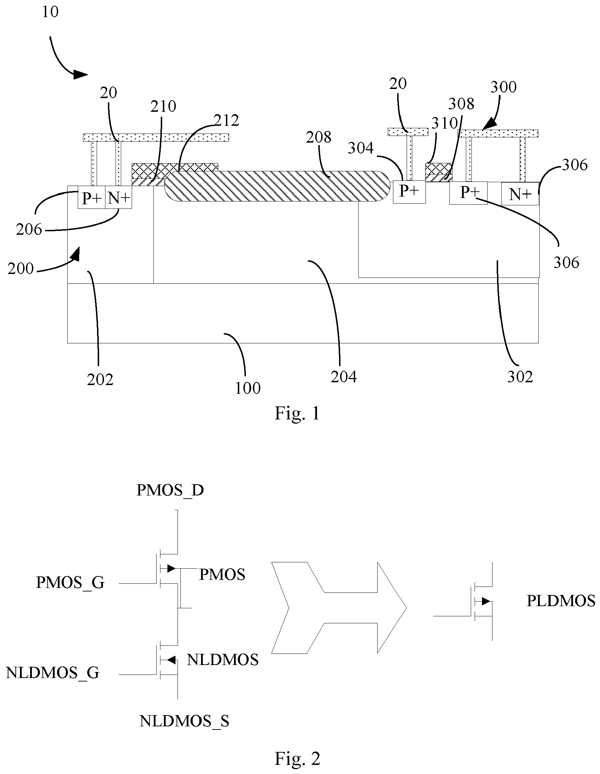

Fig. 1 shows a schematic diagram of a high voltage P-type lateral double-diffused metal oxide semiconductor field effect transistor in an embodiment. As shown in Fig. 1, the high voltage P-type lateral double-diffused metal oxide semiconductor field effect transistor (high voltage PLDMOS transistor) 10 includes a substrate 100; an N-type lateral double-diffused metal oxide semiconductor field effect transistor (NLDMOS transistor) portion 200 located on the substrate 100; and a P-type metal oxide semiconductor field effect transistor (PMOS transistor) portion 300 located at a drain of the N-type lateral double-diffused metal oxide semiconductor field effect transistor 200.

In the embodiment, the substrate 100 is a P-type substrate. In order to achieve voltage resistance of the device, a resistivity of the substrate 100 is generally larger. In the embodiment, the resistivity of the substrate 100 is from 50 Ω ● cm to 95 Ω ● cm. It can be understood that in other embodiments the resistivity of the substrate can be determined according to specific requirement of the device.

NLDMOS transistor 200 portion includes: a P well 202 and a first N well 204 located on the substrate 100; a first source lead-out region 206 located on the P well 202; a field oxide layer 208 located on the first N well 204; a first gate oxide layer 210 extending from a surface of the P well 202 to a surface of the first N well 204; and a first polysilicon gate 212 located at surfaces of the first gate oxide layer 210 and the field oxide layer 208. The first source lead-out region 206 includes a first N-type lead-out region and a first P-type lead-out region, and is led out by a metal electrode 20 to serve as the source of NLDMOS transistor 200 and also serve as the source S of high voltage PLDMOS transistor 10. The first polysilicon gate 212 is led out by the metal electrode 20 to serve as a gate of NLDMOS transistor 200. The P well 202 is configured to provide a device conductive trench for NLDMOS transistor 200 portion, so that switching of the device can be controlled by its gate. In this embodiment, the doping concentration of the P well 202 is higher than a doping concentration of the first N well 204, so as to further improve the voltage resistance performance of PLDMOS transistor 10. In other embodiment, the doping concentration of the P well 202 can be equal to or lower than the doping concentration of the first N well 204, as long as it ensures the doping concentration of the P well 202 is within a certain reasonable range. In the embodiment, the doping concentration of the P well 202 is from 1×10¹² cm⁻³ to 1×10¹³ cm⁻³. In PLDMOS transistor 10, in order to ensure NLDMOS transistor 200 as a voltage resistance portion keeps normally open, the gate of NLDMOS transistor 200 is set to be a high level. The first N well 204 serves as a voltage resistance region of PLDMOS transistor. When PLDMOS transistor 10 is turned off, the first N well 204 can provide the voltage resistance capacity required by the device. The length of the first N well 204 can be set according to voltage resistance requirement of PLDMOS transistor 10. The first P-type lead-out region on the first source lead-out region 206 is a P+ lead-out region, and the first N-type lead-out region is an N+ lead-out region.

PMOS transistor 300 portion includes: a second N well 302 located on the substrate 100, a drain lead-out region 304 and a second source lead-out region 306 located on the second N well 302; a second gate oxide layer 308 located at a surface of the second N well 302 and between the drain lead-out region 304 and the second source lead-out region 306; and a second polysilicon gate 310 located on a surface of the second gate oxide layer 308. The drain lead-out region 304 is led out by the metal electrode 20 to serve as the drain of PMOS transistor 300 and also serve as the drain D of PLDMOS transistor 10. The second polysilicon gate 310 is led out by the metal electrode 20 to serve as the gate of PMOS transistor 300 and also serve as the gate G of PLDMOS transistor 10. The second source lead-out region 306 includes a second P-type lead-out region and a second N-type lead-out region, and they are connected by the metal electrode 20 to serve as the source of PMOS transistor 300. The second N well 302 is a channel region of PMOS transistor 300, and controls off and on of the whole PLDMOS transistor 10 by the gate of PMOS transistor 300. In the embodiment, a doping concentration of the second N well 302 is higher than a doping concentration of the first N well 204 and in contact with the first N well 204 to improve conductive performance of the channel. The doping concentration of the second N well 302 is from 1×10¹² cm⁻³ to 1×10¹³ cm⁻³. The well depth of the second N well 302 increases, so that the overlap area of the gate of PMOS transistor 10, the source lead-out region and the drain lead-out region increases, which results in increase of the parasitic capacitance and influences performance of the whole PLDMOS transistor 10. Therefore, the well depth of the second N well 302 cannot be set to be too deep. In the embodiment, a well depth of the second N well 302 is less than a well depth of the first N well 204 to decrease the parasitic capacitance. In other embodiments, the well depth of the second N well 302 can be equal to or larger than the well depth of the first N well 204. In the embodiment, the well depth of the second N well 302 is from 4 microns to 6 microns. The drain lead-out region 304 is a P+ lead-out region, and the second P-type lead-out region in the second source lead-out region 306 is a P+ lead-out region. The second N-type lead-out region is an N+ lead-out region. The field oxide layer 208 extends from the surface of the first N well 204 to the surface of the second N well 302.

Fig. 3 shows a equivalent structure of the high voltage P-type lateral double-diffused metal oxide semiconductor field effect transistor shown in Fig. 2. In order to ensure NLDMOS transistor 200 keeps normally open, the gate of NLDMOS transistor 200 is set to be a high level. It can be seen from the connection relationship of Fig. 3 that the switching characteristic of NLDMOS_G is coincident with PMOS (turned on at the same time and turned off at the same time), so as to ensure only the gate G of PMOS transistor 300 of the device can serve as the control terminal. PMOS D is the drain of PLDMOS transistor 10 and is in super high voltage when the device works; NLDMOS-S is the source of PLDMOS transistor 10. Particularly, when the gate G of the high voltage PLDMOS transistor 10 is in high level, the device is turned off and resists voltage by the longer first N well 204 as the drift region; when the gate of the high voltage PLDMOS transistor 10 is in low level, the device is turned on and current of the device passes through the second N well 302 and then flows to the first N well 204 region to form a current path.

The above high voltage PLDMOS transistor 10 can enable the device to have the performance of PMOS transistor 200 when the device is turned on by disposing PMOS transistor 300 at the drain of NLDMOS transistor 200; when turned off, the device resists the voltage by NLDMOS transistor 200, so that the voltage resistance performance of the high voltage PLDMOS transistor 10 can be achieved. Further, manufacturing of PMOS transistor 300 and NLDMOS transistor 200 is performed synchronously, so that additional process steps will not be needed. The above high voltage PLDMOS transistor 10 does not need to dispose a low-doped P-type drift region therein to achieve the voltage resistance, therefore, during the integration process, it does not need to increase the number of lithography layers and implantation, so as to have a simple manufacturing process and a lower cost.

Various technical features of the above embodiments can be combined in any way, and for simplicity of description, all possible combinations of various technical features of the above embodiments are not described. However, as long as such combinations of these technical features do not contradict with each other, they should be regarded to be within the scope described in the specification.

Although the invention is illustrated and described herein with reference to specific embodiments, the invention is not intended to be limited to the details shown. Rather, various modifications may be made in the details within the scope and range of equivalents of the claims and without departing from the invention.

## Claims

1. A high voltage P-type lateral double-diffused metal oxide semiconductor field effect transistor, comprising:
a substrate;
an N-type lateral double-diffused metal oxide semiconductor field effect transistor formed on the substrate; and
a P-type metal oxide semiconductor field effect transistor formed at a drain of the N-type lateral double-diffused metal oxide semiconductor field effect transistor;
wherein a gate of the P-type metal oxide semiconductor field effect transistor serves as a gate of the high voltage P-type lateral double-diffused metal oxide semiconductor field effect transistor; a drain of the P-type metal oxide semiconductor field effect transistor serves as a drain of the high voltage P-type lateral double-diffused metal oxide semiconductor field effect transistor; a source of the N-type lateral double-diffused metal oxide semiconductor field effect transistor serves as a source of the high voltage P-type lateral double-diffused metal oxide semiconductor field effect transistor.

2. The high voltage P-type lateral double-diffused metal oxide semiconductor field effect transistor of claim 1, **characterized in that**, the substrate is a P-type substrate.

3. The high voltage P-type lateral double-diffused metal oxide semiconductor field effect transistor of claim 2, **characterized in that**, a resistivity of the substrate is from 50Ω·cm to 95Ω·cm.

4. The high voltage P-type lateral double-diffused metal oxide semiconductor field effect transistor of claim 1, **characterized in that**, the N-type lateral double-diffused metal oxide semiconductor field effect transistor comprises:
a P well located on the substrate;
a first N well located on the substrate;
a first source lead-out region located on the P well and led out by a metal electrode to serve as the source of the N-type lateral double-diffused metal oxide semiconductor field effect transistor;
a field oxide layer located on the first N well;
a first gate oxide layer extending from a surface of the P well to a surface of the first N well;
a first polysilicon gate located at surfaces of the first gate oxide layer and the field oxide layer and led out by a metal electrode to serve as a gate of the N-type lateral double-diffused metal oxide semiconductor field effect transistor.

5. The high voltage P-type lateral double-diffused metal oxide semiconductor field effect transistor of claim 4, **characterized in that**, a doping concentration of the P well is from 1×10¹² cm⁻³ to 1×10¹³ cm⁻³.

6. The high voltage P-type lateral double-diffused metal oxide semiconductor field effect transistor of claim 4, **characterized in that**, the gate of the N-type lateral double-diffused metal oxide semiconductor field effect transistor is in high level.

7. The high voltage P-type lateral double-diffused metal oxide semiconductor field effect transistor of claim 4, **characterized in that**, the first source lead-out region comprises a first P-type lead-out region and a first N-type lead-out region, and the first N-type lead-out region is connected to the first P-type lead-out region via a metal electrode.

8. The high voltage P-type lateral double-diffused metal oxide semiconductor field effect transistor of claim 4, **characterized in that**, a doping concentration of the P well is higher than a doping concentration of the first N well.

9. The high voltage P-type lateral double-diffused metal oxide semiconductor field effect transistor of claim 4, **characterized in that**, the P-type metal oxide semiconductor field effect transistor comprises:
a second N well located on the substrate and in contact with the first N well;
a drain lead-out region located on the second N well and led out by a metal electrode to serve as the drain of the P-type metal oxide semiconductor field effect transistor;
a second source lead-out region located on the second N well and led out by a metal electrode to serve as a source of the P-type metal oxide semiconductor field effect transistor;
a second gate oxide layer located at a surface of the second N well and between the second source lead-out region and the drain lead-out region; and
a second polysilicon gate formed on the second gate oxide layer and led out by a metal electrode to serve as the gate of the P-type metal oxide semiconductor field effect transistor.

10. The high voltage P-type lateral double-diffused metal oxide semiconductor field effect transistor of claim 9, **characterized in that**, the second source lead-out region comprises a second P-type lead-out region and a second N-type lead-out region, the second N-type lead-out region is connected to the second P-type lead-out region via a metal electrode.

11. The high voltage P-type lateral double-diffused metal oxide semiconductor field effect transistor of claim 9, **characterized in that**, the field oxide layer extends from the surface of the first N well to the surface of the second N well.

12. The high voltage P-type lateral double-diffused metal oxide semiconductor field effect transistor of claim 9, **characterized in that**, a doping concentration of the second N well is higher than a doping concentration of the first N well.

13. The high voltage P-type lateral double-diffused metal oxide semiconductor field effect transistor of claim 9, **characterized in that**, a doping concentration of the second N well is from 1×10¹² cm⁻³ to 1×10¹³ cm⁻³.

14. The high voltage P-type lateral double-diffused metal oxide semiconductor field effect transistor of claim 9, **characterized in that**, a well depth of the second N well is less than or equal to a well depth of the first N well.

15. The high voltage P-type lateral double-diffused metal oxide semiconductor field effect transistor of claim 9, **characterized in that**, a well depth of the second N well is from 4 microns to 6 microns.
